# EUROPEAN PATENT APPLICATION

(11) **EP 4 776 782 A1**
(43) Date of publication of application: **15.07.2026**
(21) Application number: 25800687.3
(22) Date of filing: 29.07.2025
(51) Int. Cl.: H10B 12/00, G11C 11/411, G11C 11/413

(54) **SEMICONDUCTOR DEVICE AND PREPARATION METHOD FOR SEMICONDUCTOR DEVICE**

(30) Priority: 18.10.2024 CN 202411455777
(71) Applicant: CXMT Corporation, Hefei, Anhui 230601 (CN)
(72) Inventor: CAO, Kanyu, Hefei, Anhui 230601 (CN); DU, Guoan, Hefei, Anhui 230601 (CN); DENG, Fangxin, Hefei, Anhui 230601 (CN); CAO, Yu, Hefei, Anhui 230601 (CN)
(74) Representative: Gulde & Partner
(86) International application number: PCT/CN2025/111107
(87) International publication number: WO 2026/081605

(57) **Abstract**

A semiconductor device and a manufacturing method for a semiconductor device are provided. The semiconductor device includes a first semiconductor structure, a second semiconductor structure, a third semiconductor structure, a first bit-line connection line, and a second bit-line connection line. The first semiconductor structure includes a sense amplifier circuit. The second semiconductor structure is connected to the first semiconductor structure through bonding, and includes a first memory cell. The third semiconductor structure is connected to the second semiconductor structure through bonding, and includes a second memory cell. The first bit-line connection line is associated with the first memory cell, and the second bit-line connection line is associated with the second memory cell. The first bit-line connection line and the second bit-line connection line are coupled to each other for comparison by means of the sense amplifier circuit. A length difference between the first bit-line connection line and the second bit-line connection line is less than or equal to 2 micrometers. In this case, coupling capacitance between adjacent bit lines can be reduced, an anti-crosstalk capability can be improved, a time delay difference of signal transmission can be reduced, and stability and reliability of the device can be improved.

## Description

This application is based on and claims priority of the Chinese Patent Application No. 202411455777.7, filed with China National Intellectual Property Administration on October 18, 2024 and entitled "SEMICONDUCTOR DEVICE AND MANUFACTURING METHOD FOR SEMICONDUCTOR DEVICE". The above-referenced application is incorporated herein by reference in its entirety.

### TECHNICAL FIELD

This application relates to the field of integrated circuit technologies, and in particular, to a semiconductor device and a manufacturing method for a semiconductor device.

### BACKGROUND

Recently, as information and communication apparatuses are multi-functionalized, a memory apparatus with a high density, a high capacity and a high degree of integration has been required or expected. Therefore, a vertical channel transistor is provided to improve a density of a memory apparatus, and a capacity and a degree of integration of the memory apparatus are improved through vertical stacking of a multi-layer memory apparatus.

However, in an architecture of a vertically stacked memory apparatus, a complex and crowded wiring design may be required to connect a memory cell to a logic control circuit, e.g., a sense amplifier circuit. Time delays of signal transmission may be different due to a length difference between two bit lines coupled to each other for comparison in the same sense amplifier circuit. Particularly in a high-speed circuit, even a minor difference may lead to a data read error, which affects circuit stability and reliability.

### SUMMARY

Based on this, embodiments of this application provide a semiconductor device and a manufacturing method for a semiconductor device. The semiconductor device has advantages such as a high density, a high capacity, and a high degree of integration, a small length difference between two bit lines coupled to each other for comparison in the same sense amplifier circuit, and a strong anti-interference capability.

According to a first aspect, this application provides a semiconductor device according to some embodiments, including:
a first semiconductor structure, the first semiconductor structure including a sense amplifier circuit;
a second semiconductor structure, the second semiconductor structure being connected to the first semiconductor structure through bonding, and the second semiconductor structure including a first memory cell;
a third semiconductor structure, the third semiconductor structure being connected to the second semiconductor structure through bonding, and the third semiconductor structure including a second memory cell;
a first bit-line connection line, the first bit-line connection line being associated with the first memory cell; and
a second bit-line connection line, the second bit-line connection line being associated with the second memory cell.

The first bit-line connection line and the second bit-line connection line are coupled to each other for comparison by means of the sense amplifier circuit.

A length difference between the first bit-line connection line and the second bit-line connection line is less than or equal to 2 micrometers.

In some embodiments, the first memory cell includes a first memory array and a second memory array, and the first memory array and the second memory array are on the same horizontal plane.

The second memory cell includes a third memory array and a fourth memory array, and the third memory array and the fourth memory array are on the same horizontal plane.

The third memory array is close to the first memory array, and the fourth memory array is close to the second memory array.

In some embodiments, the first bit-line connection line is associated with the first memory array.

The second bit-line connection line is associated with the third memory array.

In some embodiments, the first bit-line connection line is associated with the first memory array.

The second bit-line connection line is associated with the fourth memory array.

In some embodiments, the first memory cell includes a first bit line, a first transistor, and a first capacitor. The first capacitor, the first transistor, and the first bit line are stacked in a direction perpendicular to the second semiconductor structure.

The second memory cell includes a second bit line, a second transistor, and a second capacitor. The second bit line, the second transistor, and the second capacitor are stacked in a direction perpendicular to the third semiconductor structure.

The first bit-line connection line is connected to the first bit line.

The second bit-line connection line is connected to the second bit line.

In some embodiments, the second semiconductor structure includes a surface close to the first semiconductor structure and a surface close to the third semiconductor structure.

The third semiconductor structure includes a surface close to the second semiconductor structure and a surface away from the second semiconductor structure.

The first bit line is located on the surface that is of the second semiconductor structure and that is close to the third semiconductor structure.

The second bit line is located on the surface that is of the third semiconductor structure and that is close to the second semiconductor structure.

In some embodiments, the first semiconductor structure further includes a first interconnection structure, and the first interconnection structure is located on a surface that is of the first semiconductor structure and that is close to the second semiconductor structure. The first interconnection structure is connected to the sense amplifier circuit, and is bonded to the second semiconductor structure.

The second semiconductor structure further includes a second interconnection structure, and the second interconnection structure is located on the surface that is of the second semiconductor structure and that is close to the first semiconductor structure. The second interconnection structure is bonded to the first semiconductor structure.

The second semiconductor structure further includes a third interconnection structure, and the third interconnection structure includes a first through connection member, a first bit-line connection member, and a first contact member. The first through connection member is connected to the second interconnection structure. The first bit-line connection member is separately connected to the first bit line and the first through connection member. The first contact member is located on the surface that is of the second semiconductor structure and that is close to the third semiconductor structure, is connected to the first through connection member, and is bonded to the third semiconductor structure.

The third semiconductor structure further includes a fourth interconnection structure, and the fourth interconnection structure includes a second through connection member, a second bit-line connection member, and a second contact member. The second contact member is located on the surface that is of the third semiconductor structure and that is close to the second semiconductor structure, and is bonded to the first contact member. The second bit-line connection member is separately connected to the second bit line and the second contact member, and the second through connection member is connected to the second contact member.

In some embodiments, positions at which multiple first bit-line connection members are connected to multiple first bit lines are staggered.

Positions at which multiple second bit-line connection members are connected to multiple second bit lines are staggered.

In some embodiments, an effective length of the first bit-line connection member is equal to an effective length of the second bit-line connection member coupled to a same sense amplifier circuit.

In some embodiments, the third semiconductor structure further includes a lead-out structure. The lead-out structure is located on the surface that is of the third semiconductor structure and that is away from the second semiconductor structure, and is connected to the second through connection member.

According to a second aspect, this application further provides a manufacturing method for a semiconductor device according to some embodiments, including the steps as follows.

A first semiconductor structure is provided, and a sense amplifier circuit is formed in the first semiconductor structure.

A second semiconductor structure is provided, and a first memory cell is formed in the second semiconductor structure.

A third semiconductor structure is provided, and a second memory cell is formed in the third semiconductor structure.

The third semiconductor structure is formed on the second semiconductor structure through bonding.

The second semiconductor structure is formed on the first semiconductor structure through bonding.

A first bit-line connection line is formed. The first bit-line connection line is associated with the first memory cell.

A second bit-line connection line is formed. The second bit-line connection line is associated with the second memory cell.

The first bit-line connection line and the second bit-line connection line are coupled to each other for comparison by means of the sense amplifier circuit.

A length difference between the first bit-line connection line and the second bit-line connection line is less than or equal to 2 micrometers.

In some embodiments, providing of the first semiconductor structure includes the step as follows.

A first substrate is provided, and the sense amplifier circuit and a first interconnection structure are formed on the first substrate.

Formation of the first memory cell in the second semiconductor structure includes the step as follows.

A second substrate is provided, and a first bit line, a first transistor, and a first capacitor are formed on the second substrate. The first bit line, the first transistor, and the first capacitor are stacked in a vertical direction.

Formation of the second memory cell in the third semiconductor structure includes the step as follows.

A third substrate is provided, and a second bit line, a second transistor, and a second capacitor are formed on the third substrate. The second bit line, the second transistor, and the second capacitor are stacked in the vertical direction.

In some embodiments, formation of the third semiconductor structure on the second semiconductor structure through bonding includes the steps as follows.

A first carrier plate and a second carrier plate are formed respectively on the second semiconductor structure and the third semiconductor structure.

The second semiconductor structure and the third semiconductor structure are flipped to remove the second substrate and the third substrate.

A first bit-line connection member and a first contact member are formed in the second semiconductor structure.

A second bit-line connection member and a second contact member are formed in the third semiconductor structure.

The second semiconductor structure is flipped, so that the second semiconductor structure is bonded to the third semiconductor structure.

In some embodiments, formation of the second semiconductor structure on the first semiconductor structure through bonding includes the steps as follows.

The first carrier plate is removed, and a first through connection member and a second interconnection structure are formed in the second semiconductor structure.

The second semiconductor structure is flipped, so that the second semiconductor structure is bonded to the first semiconductor structure.

In some embodiments, after the second semiconductor structure is bonded to the first semiconductor structure, the method further includes the step as follows.

A third carrier plate is removed, and a second through connection member and a lead-out structure are formed in the third semiconductor structure.

The semiconductor structure and the manufacturing method therefor provided in this application have at least the following beneficial effects:

According to the semiconductor device and the manufacturing method for a semiconductor device provided in this application, the first semiconductor structure, the second semiconductor structure, and the third semiconductor structure are vertically stacked in the semiconductor device, so that a memory density and a degree of integration of the semiconductor device can be improved. The two bit lines coupled to each other for comparison in the same sense amplifier circuit are respectively associated with the second memory cell and the third memory cell, so that coupling capacitance between adjacent bit lines can be reduced, and an anti-crosstalk capability can be improved. In addition, a length difference between connection lines of the two bit lines is less than or equal to 2 micrometers, which can effectively prevent a time delay difference of signal transmission, and improve circuit stability and reliability.

### BRIEF DESCRIPTION OF DRAWINGS

To describe the technical solutions in the embodiments of this application or the conventional technologies more clearly, the following briefly describes the accompanying drawings required for describing the embodiments or the conventional technologies. Clearly, the accompanying drawings in the following description show merely some embodiments of this application, and a person of ordinary skill in the art may still derive other drawings from these accompanying drawings without creative efforts.
FIG. 1 is a schematic diagram of a sectional view of a semiconductor device according to an embodiment of this application;
FIG. 2 is a schematic diagram of a sectional view of another semiconductor device according to an embodiment of this application;
FIG. 3 is a schematic diagram of a partially enlarged sectional view of a semiconductor structure described in FIG. 1;
FIG. 4 is a simplified and three-dimensional schematic diagram of a part of a semiconductor structure described in FIG. 1; and
FIG. 5A, FIG. 5B, FIG. 5C, FIG. 6A, FIG. 6B, FIG. 7A, FIG. 7B, FIG. 8, and FIG. 9 show a manufacturing process for forming the semiconductor structure in FIG. 3 according to an embodiment of this application.

Descriptions of reference numerals:
101: first substrate; 102, 102A, 120B: sense amplifier circuit; 103, 103A, 103B: first interconnection structure; 1: first semiconductor structure; 201: second substrate; 2021: first bit line; 2022: first transistor; 2023: first capacitor; 203: first carrier plate; 2041: first bit-line connection member; 2042: first contact member; 2043: first through connection member; 2044: second interconnection structure; 2: second semiconductor structure; 202A: first memory array; 202B: second memory array; 204A, 204B: first bit-line connection line; 301: third substrate; 3021: second bit line; 3022: second transistor; 3023: second capacitor; 303: second carrier plate; 3041: second bit-line connection member; 3042: second contact member; 3043: second through connection member; 305: lead-out structure; 3: third semiconductor structure; 302A: third memory array; 302B: fourth memory array; 304A, 304B: second bit-line connection line.

### DESCRIPTION OF EMBODIMENTS

For ease of understanding of this application, this application is described more comprehensively below with reference to related accompanying drawings. A preferred embodiment of this application is provided in the accompanying drawings. However, this application may be implemented in many different forms, and is not limited to the embodiments described herein. Instead, these embodiments are provided to make the content of this application more thorough and comprehensive.

Unless otherwise defined, all technical and scientific terms employed herein have meanings the same as those commonly understood by a person skilled in the art of this application. In this application, terms employed in the specification of this application are merely intended to describe objectives of specific embodiments, but are not intended to limit this application.

It should be understood that an element or a layer may be directly on, adjacent to, or connected to another element or layer or there may be an intermediate element or layer when the element or the layer is referred to as "on...", "adjacent to...", or "connected to...". It should be understood that although the terms "first", "second", and the like may be employed to describe various elements, components, regions, layers, doping types, and/or portions, these elements, components, regions, layers, doping types, and/or portions should not be limited by these terms. These terms are merely employed to distinguish one element, component, region, layer, doping type, or portion from another element, component, region, layer, doping type, or portion. Therefore, without departing from the teachings of this application, a first element, component, region, layer, doping type, or portion discussed below may be represented as a second element, component, region, layer, or portion. For example, a first doped region may be referred to as a second doped region, and similarly, a second doped region may be referred to as a first doped region. The first doped region and the second doped region are different doped regions.

Spatial relationship terms, e.g., "above...", may be employed herein to describe a relationship between one element or feature and another element or feature shown in the figures. It should be understood that in addition to the orientations shown in the figures, the spatial relationship terms further include different orientations of devices in application and operation. For example, an element or a feature described as "above..." is oriented to be "below" another element or feature if the devices in the accompanying drawings are flipped. Therefore, the example terms "above..." may include orientations of being above and being below. In addition, the devices may alternatively include other orientations (e.g., rotation by 90 degrees or another orientation), and the spatial descriptors employed herein are interpreted accordingly.

As employed herein, the singular forms of "a", "an", and "the" may also be intended to include plural forms unless otherwise clearly specified in the context. It should also be understood that, the presence of the feature, integer, step, operation, element, and/or component can be determined without ruling out the presence or addition of one or more other features, integers, steps, operations, elements, components, and/or groups when the term "constitute" and/or the term "include" are/is employed in the specification. Moreover, as employed herein, the term "and/or" includes any and all combinations of the related items listed.

The embodiments of the disclosure are described herein with reference to a cross-sectional view serving as a schematic diagram of an ideal embodiment (and an intermediate structure) of this application. In this way, a variation in the shown shape caused by, e.g., a manufacturing technology and/or a tolerance can be expected. Therefore, the embodiments of this application should not be limited to specific shapes of the regions shown herein, but include a shape deviation caused by, e.g., a manufacturing technology. The regions shown in the figure are essentially examples. The shapes of the regions do not represent actual shapes of the regions of the device, and do not limit the scope of this application.

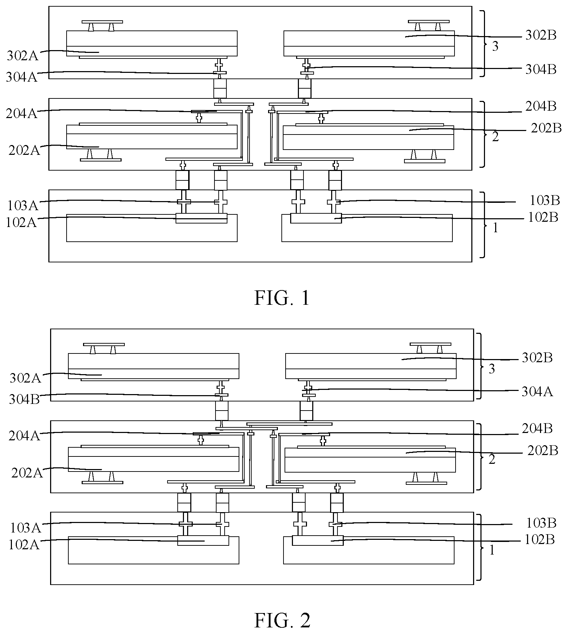

FIG. 1 is a schematic diagram of a sectional view of a semiconductor device according to an embodiment of this application. In some embodiments, the semiconductor device includes a first semiconductor structure 1, a second semiconductor structure 2, a third semiconductor structure 3, a first bit-line connection line 204A, 204B, and a second bit-line connection line 304A, 304B. The first semiconductor structure 1 includes a sense amplifier circuit 102A, 102B. The second semiconductor structure 2 is connected to the first semiconductor structure 1 through bonding, and includes a first memory cell 202A, 202B. The third semiconductor structure 3 is connected to the second semiconductor structure 2 through bonding, and includes a second memory cell 302A, 302B. The first bit-line connection line 204A, 204B is associated with the first memory cell 202A, 202B, and the second bit-line connection line 304A, 304B is associated with the second memory cell 302A, 302B. The first bit-line connection line 204A, 204B and the second bit-line connection line 304A, 304B are coupled to each other for comparison by means of the sense amplifier circuit 102A, 102B. A length difference between the first bit-line connection line 204A, 204B and the second bit-line connection line 304A, 304B is less than or equal to 2 micrometers. The first semiconductor structure 1, the second semiconductor structure 2, and the third semiconductor structure 3 are vertically stacked, so that a memory density and a degree of integration of the semiconductor device can be improved. The two bit lines coupled to each other for comparison in the same sense amplifier circuit 102A, 102B are respectively associated with the first memory cell 202A, 202B and the second memory cell 302A, 302B, so that coupling capacitance between adjacent bit lines can be reduced, and an anti-crosstalk capability can be improved. In addition, a length difference between connection lines of the two bit lines is less than or equal to 2 micrometers, which can effectively reduce a time delay difference of signal transmission, and improve circuit stability and reliability.

In some embodiments of this application, the first semiconductor structure 1, the second semiconductor structure 2, and the third semiconductor structure 3 are separately manufactured, and then are vertically stacked through wafer bonding, die bonding, or die-to-wafer bonding. A first substrate of the first semiconductor structure 1 may be a single-crystal silicon wafer, a polysilicon wafer, a germanium-silicon wafer, a sapphire wafer, a silicon carbide wafer, a silicon on insulator wafer, a germanium on insulator wafer, a glass wafer, a group III-V compound wafer (e.g., silicon nitride or gallium arsenide), an oxide semiconductor wafer, or another wafer on which a semiconductor device is formed. In addition to the sense amplifier circuit, a word line driver circuit, a power supply circuit, a clock circuit, various interface circuits, and another control circuit may be formed. The second semiconductor structure 2 and the third semiconductor structure 3 respectively include the first memory cell 202A, 202B and the second memory cell 302A, 302B. Generally, the second semiconductor structure 2 and the third semiconductor structure 3 may be interchangeable. The second semiconductor structure 2 and the third semiconductor structure 3 are named merely for distinction, but not for a specific limitation. A substrate of each of the second semiconductor structure 2 and the third semiconductor structure 3 may be a single-crystal silicon wafer, a polysilicon wafer, a germanium-silicon wafer, a sapphire wafer, a silicon carbide wafer, a silicon on insulator wafer, a germanium on insulator wafer, a glass wafer, a group III-V compound wafer (e.g., silicon nitride or gallium arsenide), an oxide semiconductor wafer, or another wafer on which a memory cell is formed. The memory cell may be a dynamic random access memory, a ferroelectric memory, a resistive random access memory, a magnetoresistive random access memory, or another memory cell. In this application, the dynamic random access memory cell is employed as an example for description.

In some embodiments of this application, the first bit-line connection line 204A, 204B and the second bit-line connection line 304A, 304B are coupled to each other for comparison by means of the sense amplifier circuit 102A, 102B. The first bit-line connection line 204A, 204B and the second bit-line connection line 304A, 304B are wires that connect bit lines to the sense amplifier circuit 102A, 102B and that have electrical conductivity. Lengths of the first bit-line connection line 204A, 204B and the second bit-line connection line 304A, 304B are a shortest distance for charge transmission from the sense amplifier circuit 102A, 102B to the bit line. The sense amplifier circuit 102A, 102B transmits a bit line amplification signal to the bit line through the bit-line connection lines, so as to control the memory cell. The first bit-line connection line 204A, 204B is associated with the first memory cell, and the second bit-line connection line 304A, 304B is associated with the second memory cell, so that coupling capacitance between adjacent bit lines can be reduced, signal crosstalk between adjacent bit lines can be prevented, and signal integrity and reliability can be improved. The length difference between the first bit-line connection line 204A, 204B and the second bit-line connection line 304A, 304B is less than or equal to 2 micrometers, and may be another value less than 2 micrometers, such as 1.8 micrometers, 1.5 micrometers, 1.3 micrometers, 1 micrometer, or 0.8 micrometer. A smaller length difference indicates a smaller time delay difference of signal transmission in the bit-line connection lines and a smaller probability of causing a data read error, thereby improving circuit stability and reliability. The first bit-line connection line 204A, 204B and the second bit-line connection line 304A, 304B each are formed by connecting multiple wiring layers. Each of the wiring layers is a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. Materials of the wiring layers may be the same or different.

Still referring to FIG. 1, in some embodiments, the first memory cell includes a first memory array 202A and a second memory array 202B, and the first memory array 202A and the second memory array 202B are on the same horizontal plane. The second memory cell includes a third memory array 302A and a fourth memory array 302B, and the third memory array 302A and the fourth memory array 302B are on the same horizontal plane. The first memory cell is located in the second semiconductor structure 2, and the second memory cell is located in the third semiconductor structure 3. The first memory array 202A and the second memory array 202B are stacked with the third memory array 302A and the fourth memory array 302B in a vertical direction. The third memory array 302A and the first memory array 202A overlap in the vertical direction, and the fourth memory array 302B and the second memory array 202B overlap in the vertical direction.

Still referring to FIG. 1, in some embodiments, the first bit-line connection line 204A is led out from the sense amplifier circuit 102A, and is associated with the first memory array 202A. The second bit-line connection line 304A coupled to the first bit-line connection line 204A for comparison in the sense amplifier circuit 102A is led out from the sense amplifier circuit 102A, and is associated with the second memory array 302A. The first bit-line connection line 204B is led out from the sense amplifier circuit 102B, and is associated with the first memory array 202B. The second bit-line connection line 304B coupled to the first bit-line connection line 204B for comparison in the sense amplifier circuit 102B is led out from the sense amplifier circuit 102B, and is associated with the second memory array 302B. The third memory array 302A and the first memory array 202A overlap in the vertical direction, and the fourth memory array 302B and the second memory array 202B overlap in the vertical direction. The first bit-line connection line 202A and the second bit-line connection line 302A are disposed parallel to each other, and the first bit-line connection line 202B and the second bit-line connection line 302B are disposed parallel to each other. Bit-line connection line circuits in the second semiconductor structure 2 and the third semiconductor structure 3 may be manufactured by means of the same process, thereby reducing manufacturing costs.

FIG. 2 is a schematic diagram of a sectional view of another semiconductor device according to an embodiment of this application. In some embodiments, the first bit-line connection line 204A is led out from the sense amplifier circuit 102A, and is associated with the first memory array 202A. The second bit-line connection line 304A coupled to the first bit-line connection line 204A for comparison in the sense amplifier circuit 102A is led out from the sense amplifier circuit 102A, and is associated with the second memory array 302B. The first bit-line connection line 204B is led out from the sense amplifier circuit 102B, and is associated with the first memory array 202B. The second bit-line connection line 304B coupled to the first bit-line connection line 204B for comparison in the sense amplifier circuit 102B is led out from the sense amplifier circuit 102B, and is associated with the second memory array 302A. The third memory array 302A and the first memory array 202A overlap in the vertical direction, and the fourth memory array 302B and the second memory array 202B overlap in the vertical direction. The first bit-line connection line 202A and the second bit-line connection line 302A have different wiring directions, and the first bit-line connection line 202B and the second bit-line connection line 302B have different wiring directions. In the third semiconductor structure 3, the second bit-line connection line 302A and the second bit-line connection line 302B are disposed in a crossing and detouring manner, so that a coupling effect of a bit line between adjacent memory arrays can be reduced, an anti-interference capability can be improved, and stability and reliability of the semiconductor device can be enhanced.

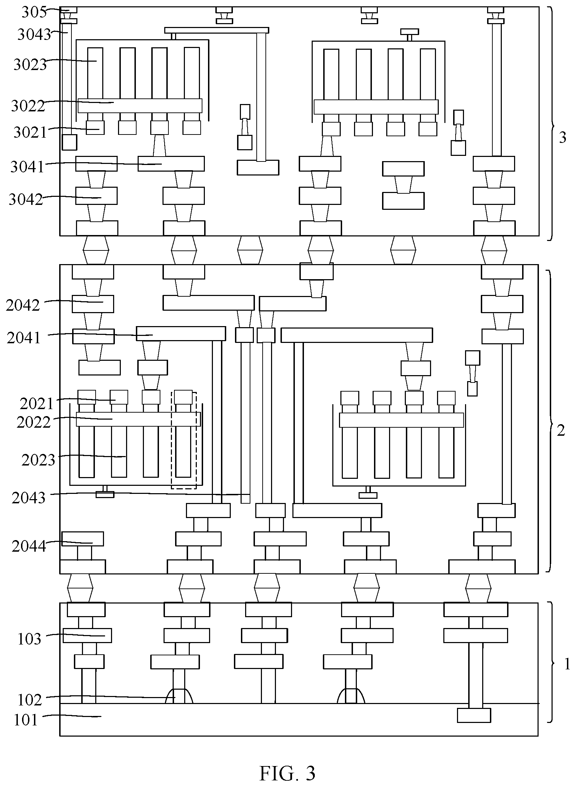

FIG. 3 is a schematic diagram of a partially enlarged sectional view of a semiconductor structure described in FIG. 1. In some embodiments, the first memory cell includes a first bit line 2021, a first transistor 2022, and a first capacitor 2023, and the first bit line 2021, the first transistor 2022, and the first capacitor 2023 are stacked in a vertical direction. The second memory cell includes a second bit line 3021, a second transistor 3022, and a second capacitor 3023, and the second bit line 3021, the second transistor 3022, and the second capacitor 3023 are stacked in the vertical direction. The first bit-line connection line is connected to the first bit line 2021, and the second bit-line connection line is connected to the second bit line 3021. The first bit line 2021 is connected to the first transistor 2022 arranged perpendicular to a sectional direction, and the second bit line 3021 is connected to the second transistor 3022 arranged perpendicular to the sectional direction. The first bit line 2021 and the second bit line 3021 each are a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. The first transistor 2022 and the second transistor 3022 are vertical channel transistors, and a channel material may be one or more of the following semiconductor materials: silicon (Si), polysilicon (poly-Si, p-Si), amorphous silicon (amorphous-Si, a-Si), indium gallium zinc oxide (In-Ga-Zn-O, IGZO) diversified compounds, zinc oxide (ZnO), ITO, titanium dioxide (TiO₂), or molybdenum disulfide (MoS₂). The gate may be of a single-gate, a double-gate, a triple-gate, or a gate-all-around structure. A material of the gate is a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. The first capacitor 2023 and the second capacitor 3023 are configured to store information, and each may be a cylindrical capacitor, a box capacitor, a barrel capacitor, or a blade capacitor, or may be of a capacitor structure in another shape. Similarly, the capacitors each may alternatively be a memory cell of another type, such as a ferroelectric storage capacitor, a phase change memory, a resistive random access memory, or a magnetoresistive random access memory.

Still referring to FIG. 3, in some embodiments, the second semiconductor structure 2 includes a surface close to the first semiconductor structure 1 and a surface close to the third semiconductor structure 3. The third semiconductor structure 3 includes a surface close to the second semiconductor structure 2 and a surface away from the second semiconductor structure 2. The first bit line 2021 is located on the surface that is of the second semiconductor structure 2 and that is close to the third semiconductor structure 3, and the second bit line 3021 is located on the surface that is of the third semiconductor structure 3 and that is close to the second semiconductor structure 2. The first semiconductor structure 1 and the second semiconductor structure 2 are stacked with a physical distance between the first bit line 2021 and the second bit line 3021 being shortest, which helps reduce the length difference between the first bit-line connection line and the second bit-line connection line coupled to each other for comparison in the same sense amplifier circuit, shorten a time delay difference of signal transmission, and improve circuit stability and reliability.

Still referring to FIG. 3, in some embodiments, the first semiconductor structure 1 further includes a first interconnection structure 103. The first interconnection structure 103 is located on a surface that is of the first semiconductor structure 1 and that is close to the second semiconductor structure 2. The first interconnection structure 103 is connected to the sense amplifier circuit 102, and is bonded to the second semiconductor structure 2. The second semiconductor structure 2 further includes a second interconnection structure 2044. The second interconnection structure 2044 is located on the surface that is of the second semiconductor structure 2 and that is close to the first semiconductor structure 1. The second interconnection structure 2044 is bonded to the first semiconductor structure 1. The second semiconductor structure 2 further includes a third interconnection structure. The third interconnection structure includes a first through connection member 2043, a first bit-line connection member 2041, and a first contact member 2042. The first through connection member 2043 is connected to the second interconnection structure 2044. The first bit-line connection member 2041 is separately connected to the first bit line 2021 and the first through connection member 2043. The first contact member 2042 is located on the surface that is of the second semiconductor structure 2 and that is close to the third semiconductor structure 3, is connected to the first through connection member 2043, and is bonded to the third semiconductor structure 3. The third semiconductor structure 3 further includes a fourth interconnection structure. The fourth interconnection structure includes a second through connection member 3043, a second bit-line connection member 3041, and a second contact member 3042. The second contact member 3042 is located on the surface that is of the third semiconductor structure 3 and that is close to the second semiconductor structure 2, and is bonded to the first contact member 2042. The second bit-line connection member 3041 is separately connected to the second bit line 3021 and the second contact member 3042. The second through connection member 3043 is connected to the second contact member 3042.

Still referring to FIG. 3, in some embodiments, the first interconnection structure 103 is connected to the sense amplifier circuit 102, and then is connected to the second semiconductor structure 2 through bonding. The first interconnection structure 103 may include a multi-layer wiring structure, e.g., two layers, three layers, four layers, or more. A peripheral circuit on the first semiconductor structure 1, such as the sense amplifier circuit 102, a word line driver circuit, a power supply circuit, a clock circuit, various interface circuits, and another peripheral control circuit, may be connected to the second semiconductor structure 2 and the third semiconductor structure 3 by means of the first interconnection structure 103, thereby improving a memory density and a degree of integration. A material of the first interconnection structure 103 is a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. Materials of wiring layers in the first interconnection structure 103 may be the same or different.

Still referring to FIG. 3, in some embodiments, the second interconnection structure 2044 and the third interconnection structure including the first through connection member 2043, the first bit-line connection member 2041, and the first contact member 2042 are located in the second semiconductor structure 2. The second interconnection structure 2044 is located on the surface that is of the second semiconductor structure 2 and that is close to the first semiconductor structure 1, and is connected to the first semiconductor structure 1 through bonding. The second interconnection structure 2044 may include a multi-layer wiring structure, e.g., two layers, three layers, four layers, or more. A control signal of the peripheral circuit in the first semiconductor structure 1 is transmitted to the second semiconductor structure 2 and the third semiconductor structure 3 by means of the second interconnection structure 2044. A material of the second interconnection structure 2044 is a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. Materials of wiring layers in the second interconnection structure 2044 may be the same or different. The first through connection member 2043 is connected to the second interconnection structure 2044, to transmit the control signal to the first bit line 2021, the gate of the first transistor 2022, and the third semiconductor structure 3. A length and a material of the first through connection member 2043 are set as required. The first bit-line connection line 2041 is separately connected to the first bit line 2021 and the first through connection member 2043. The first contact member 2042 is located on the surface that is of the second semiconductor structure 2 and that is close to the third semiconductor structure 3, is bonded to the third semiconductor structure, and is connected to the first through connection member 2043 in the second semiconductor structure 2. The first contact member 2042 may include a multi-layer wiring structure, e.g., two layers, three layers, four layers, or more. Materials of the first through connection member 2043, the first bit-line connection member 2041, and the first contact member 2042 each are a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. The materials of the first through connection member 2043, the first bit-line connection member 2041, and the first contact member 2042 may be the same or different.

Still referring to FIG. 3, in some embodiments, the second contact member 3042 is located on the surface that is of the third semiconductor structure 3 and that is close to the second semiconductor structure 2, and is bonded to the first contact member 2042. The second contact member 3042 may include a multi-layer wiring structure, e.g., two layers, three layers, four layers, or more. The control signal of the peripheral circuit in the first semiconductor structure 1 is transmitted to the third semiconductor structure 3 by means of the second contact member 3042. A material of the second contact member 3042 is a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. Materials of wiring layers in the second contact member 3042 may be the same or different. The second bit-line connection member 3041 is separately connected to the second bit line 3021 and the second contact member 3042 to perform signal control on the second bit line 3021. The second through connection member 3043 is connected to the second contact member 3042, and may connect the second transistor 3022 to the second capacitor 3023. Materials of the second contact member 3042, the second bit-line connection member 3041, and the second through connection member 3043 each are a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. The materials of the second contact member 3042, the second bit-line connection member 3041, and the second through connection member 3043 may be the same or different.

Still referring to FIG. 3, in some embodiments, the third semiconductor structure 3 further includes a lead-out structure 305. The lead-out structure 305 is located on the surface that is of the third semiconductor structure 3 and that is away from the second semiconductor structure 2, and is connected to the second through connection member 3043. The lead-out structure 305 is connected to the second through connection member 3043, so that a power supply or another control signal outside the semiconductor device is transmitted to a peripheral control circuit by means of the second through connection member 3043, the second contact member 3042, the first contact member 2042, the first through connection member 2043, the second interconnection structure 2044, and the first interconnection structure 103. Then, the control signal is transmitted from the peripheral control circuit to a memory array by means of the first interconnection structure 103, the second interconnection structure 2044, the first through connection member 2043, the first bit-line connection member 2041, the first contact member 2042, the second contact member 3042, and the second bit-line connection member 3041. The lead-out structure 305 may have one layer or more layers. A material of the lead-out structure 305 is a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like.

Still referring to FIG. 3, with reference to FIG. 1 and FIG. 2, in some embodiments, the first bit-line connection line 204A, 204B includes the first interconnection structure 103, the second interconnection structure 2044, the first through connection member 2043, and the first bit-line connection member 2041. The second bit-line connection line 304A, 304B includes the first interconnection structure 103, the second interconnection structure 2044, the first through connection member 2043, the first contact member 2042, the second contact member 3042, and the second bit-line connection member 3041. Alternatively, in some embodiments, the first bit-line connection line 204A, 204B includes the second interconnection structure 2044, the first through connection member 2043, and the first bit-line connection member 2041. The second bit-line connection line 304A, 304B includes the second interconnection structure 2044, the first through connection member 2043, the first contact member 2042, the second contact member 3042, and the second bit-line connection member 3041. In other words, the first bit-line connection line 204A, 204B and the second bit-line connection line 304A, 304B are located only in wiring parts of the second semiconductor structure 2 and the third semiconductor structure 3. A length difference between the first bit-line connection line 204A, 204B and the second bit-line connection line 304A, 304B may be understood as an optimal conductive length of the first contact member 2042 and the second contact member 3042. Because the first contact member 2042 is connected to the second contact member 3042 through bonding, a conductive length is relatively short, which may effectively reduce the length difference between the first bit-line connection line 204A, 204B and the second bit-line connection line 304A, 304B, shorten a time delay difference of signal transmission, and improve circuit stability and reliability.

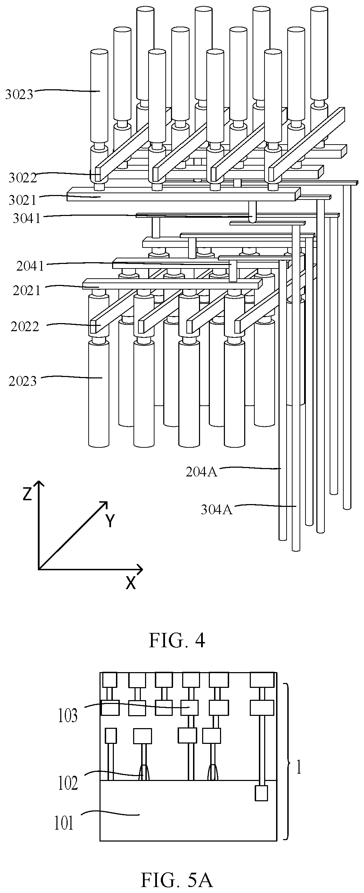

FIG. 4 is a simplified and three-dimensional schematic diagram of a part of a semiconductor structure described in FIG. 1. In some embodiments, the second semiconductor structure 2 and the third semiconductor structure 3 are stacked, which may improve a memory density. The second semiconductor structure 2 includes a first bit line 2021, a first transistor 2022, and a first capacitor 2023. The first bit line 2021, the first transistor 2022, and the first capacitor 2023 are stacked in a third direction (e.g., in a Z direction). The second semiconductor structure 2 includes a second bit line 3021, a second transistor 3022, and a second capacitor 3023. The second bit line 3021, the second transistor 3022, and the second capacitor 3023 are stacked in the third direction (e.g., in the Z direction). The first bit-line connection line 204A is connected to the first bit line 2021 by means of a first bit-line connection member 2041, and the second bit-line connection line 304A is connected to the second bit line 3021 by means of a second bit-line connection member 3041.

Still referring to FIG. 4, in some embodiments, multiple first bit lines 2021 extend in a first direction (e.g., in an X direction) and are arranged at an interval in a second direction (e.g., in a Y direction). Multiple first bit-line connection members 2041 are correspondingly connected to the first bit lines 2021, and connection positions are staggered in the first direction (e.g., in the X direction). Therefore, a process window of the first bit-line connection members 2041 can be enlarged, and a coupling effect between the first bit-line connection members 2041 can be reduced, thereby improving circuit stability and reliability. Similarly, multiple second bit lines 3021 extend in the first direction (e.g., in the X direction) and are arranged at an interval in the second direction (e.g., in the Y direction). Multiple second bit-line connection members 3041 are correspondingly connected to the second bit lines 3021, and connection positions are staggered in the first direction (e.g., in the X direction). A position at which the first bit-line connection member 2041 is connected to the first bit line 2021 overlaps a position at which the second bit-line connection member 3041 and the second bit line 3021 in a vertical direction (e.g., in the Z direction), or the first bit-line connection member 2041 and the second bit-line connection member 3041 have an equal extension length in the first direction (e.g., in the X direction). In this case, a length difference between the first bit-line connection line 204A and the second bit-line connection line 304A extending in the first direction (e.g., in the X direction) may be minimized.

FIG. 5A, FIG. 5B, FIG. 5C, FIG. 6A, FIG. 6B, FIG. 7A, FIG. 7B, FIG. 8, and FIG. 9 show a manufacturing process for forming the semiconductor structure in FIG. 3 according to an embodiment of this application. It should be understood that operations shown in the manufacturing process method are not exhaustive, and another operation may be performed before, after, or between any operation shown. In addition, some operations may be performed simultaneously or in a sequence different from a sequence shown in the figure.

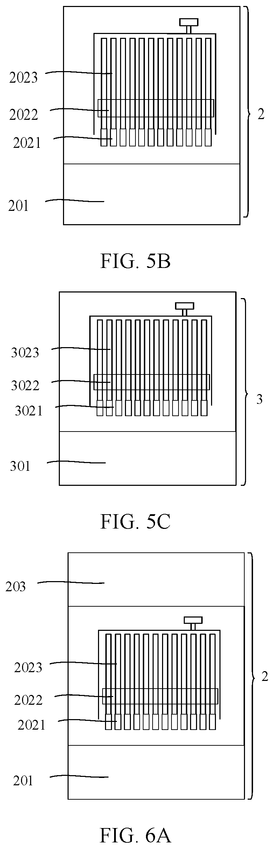

Referring to FIG. 5A, in some embodiments, the first substrate 101 is provided. The sense amplifier circuit 102, a word line driver circuit, a power supply circuit, a clock circuit, various interface circuits, and another peripheral control circuit are formed on the first substrate 101. The first interconnection structure 103 is formed on a peripheral circuit. Referring to FIG. 5B and FIG. 5C, in some embodiments, a second substrate 201 and a third substrate 301 are separately provided. A first memory cell and a second memory cell are formed respectively on the second substrate 201 and the third substrate 301. The first memory cell includes the first bit line 2021, the first transistor 2022, and the first capacitor 2023. The first bit line 2021, the first transistor 2022, and the first capacitor 2023 are stacked in a vertical direction. The second memory cell includes the second bit line 3021, the second transistor 3022, and the second capacitor 3023. The second bit line 3021, the second transistor 3022, and the second capacitor 3023 are stacked in the vertical direction. The first substrate 101, the second substrate 201, and the third substrate 301 each may be a single-crystal silicon substrate, a polysilicon substrate, a germanium-silicon substrate, a sapphire substrate, a silicon carbide substrate, a silicon on insulator substrate, a germanium on insulator substrate, a glass substrate, a group III-V compound substrate (e.g., silicon nitride or gallium arsenide), an oxide semiconductor substrate, or another substrate on which a memory cell is formed. The first substrate 101, the second substrate 201, and the third substrate 301 may be the same or different. The first memory cell and the second memory cell may be interchangeable, and there is no essential difference.

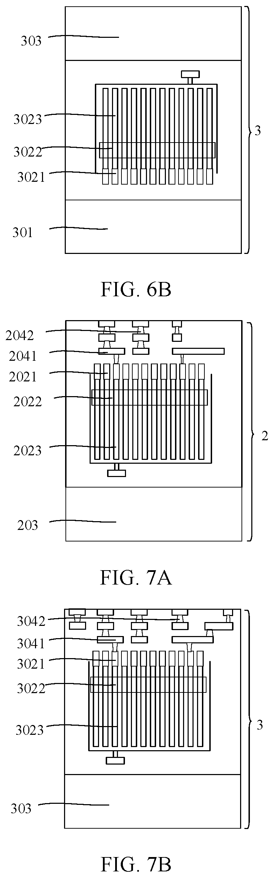

Referring to FIG. 6A and FIG. 6B, in some embodiments, a first carrier plate 203 and a second carrier plate 303 are formed respectively on the second semiconductor structure 2 and the third semiconductor structure 3. The first carrier plate 203 and the second carrier plate 303 each may be a single-crystal silicon substrate, a polysilicon substrate, a germanium-silicon substrate, a sapphire substrate, a silicon carbide substrate, a silicon on insulator substrate, a germanium on insulator substrate, a glass substrate, a group III-V compound substrate (e.g., silicon nitride or gallium arsenide), an oxide semiconductor substrate, or another substrate on which a memory cell is formed. The first carrier plate 203 and the second carrier plate 303 may be the same or different.

Referring to FIG. 7A and FIG. 7B, in some embodiments, the second semiconductor structure 2 and the third semiconductor structure 3 are separately flipped. The substrate 201 and the substrate 301 are removed through cutting and grinding, to respectively expose the first bit line 2021 and the second bit line 3021. The first bit-line connection member 2041 and the first contact member 2042 are formed in the second semiconductor structure 2. The first bit-line connection member 2041 is connected to the first bit line 2021, and the first contact member 2042 is connected to the first bit-line connection member 2041. The second bit-line connection member 3041 and the second contact member 3042 are formed in the third semiconductor structure 3. The second bit-line connection member 3041 is connected to the second bit line 3021, and the second contact member 3042 is connected to the second bit-line connection member 3041. Materials of the first bit-line connection member 2041, the first contact member 2042, the second bit-line connection member 3041, and the second contact member 3042 each are a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. The materials of the first bit-line connection member 2041, the first contact member 2042, the second bit-line connection member 3041, and the second contact member 3042 may be the same or different.

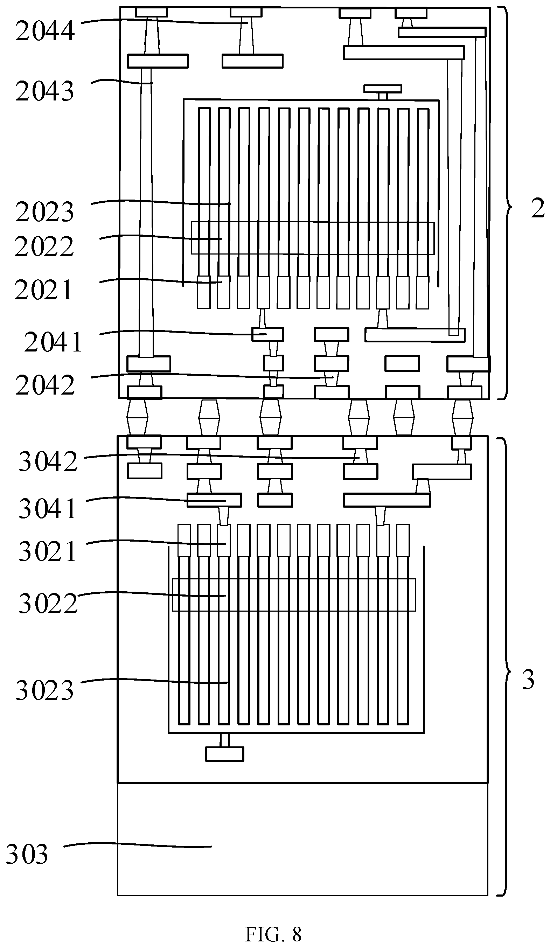

Referring to FIG. 8, in some embodiments, the second semiconductor structure 2 is flipped, so that the second semiconductor structure 2 is bonded to the third semiconductor structure 3. In other words, the first contact member 2042 is connected to the second contact member 3042 through bonding. The first carrier plate 203 is removed, and the first through connection member 2043 and the second interconnection structure 2044 are formed in the second semiconductor structure 2. The first through connection member 2043 is separately connected to the first bit-line connection member 2041 and the first contact member 2042, and the second interconnection structure 2044 is connected to the first through connection member 2043. Materials of the first through connection member 2043 and the second interconnection structure 2044 each are a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. The materials of the first through connection member 2043 and the second interconnection structure 2044 may be the same or different.

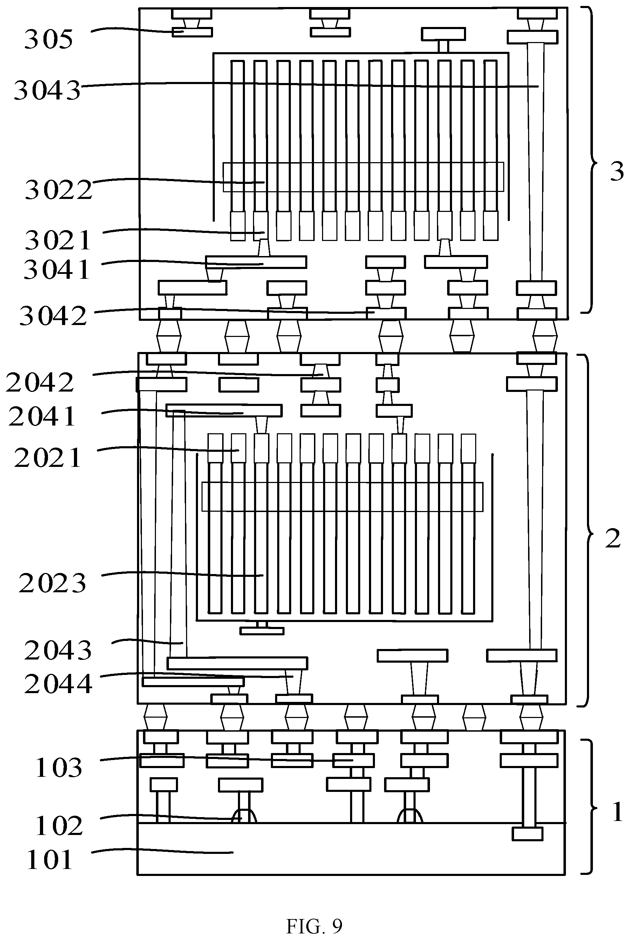

Referring to FIG. 9, in some embodiments, a bonded structure of the second semiconductor structure 2 and the third semiconductor structure 3 is flipped, so that the second semiconductor structure 2 is bonded to the first semiconductor structure 1. In other words, the first interconnection structure 103 is connected to the second interconnection structure 2044 through bonding. The second carrier plate 303 is removed, and the second through connection member 3043 and the lead-out structure 305 are formed in the third semiconductor structure. The second through connection member 3043 is connected to the second contact member 3042. The lead-out structure 305 is located on a surface of the third semiconductor structure and is connected to the second through connection member 3043. Materials of the second through connection member 3043 and the lead-out structure 305 each are a material with electrical conductivity, e.g., may be at least one of the following materials: titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), polysilicon (Si), metal silicide, or the like. The materials of the second through connection member 3043 and the lead-out structure 305 may be the same or different.

An interconnection structure and through connection member process is separately employed in the second semiconductor structure 2 and the third semiconductor structure 3, so that a through-silicon via process may not be required, thereby reducing a difficulty in the manufacturing process, and forming a semiconductor device that occupies a small space and has a high memory density. In addition, back surfaces of the second semiconductor structure 2 and the third semiconductor structure 3 are cut and ground to expose the bit lines, so that the thicknesses of the entire second semiconductor structure 2 and the entire third semiconductor structure 3 are minimized. Then, the bit-line connection members and rear end connection lines are formed on the bit lines, so that a degree of integration of the semiconductor device can be improved.

The technical features in the foregoing embodiments may be combined arbitrarily. For brevity of description, not all possible combinations of these technical features in the foregoing embodiments are described. However, as long as these combinations of technical features are not contradictory, they should all be considered within the scope described in the specification.

The foregoing embodiments represent only several implementations of this application, and are described in a relatively specific and detailed way, but should not be construed as limitations on the patent scope of this application. It should be noted that a person of ordinary skill in the art can further make several variations and improvements without departing from the concept of this application, and these variations and improvements shall fall within the protection scope of this application. Therefore, the patent protection scope of this application shall be subject to the appended claims.

## Claims

1. A semiconductor device, comprising:
a first semiconductor structure (1), the first semiconductor structure (1) comprising a sense amplifier circuit (102);
a second semiconductor structure (2), the second semiconductor structure (2) being connected to the first semiconductor structure (1) through bonding, and the second semiconductor structure (2) comprising a first memory cell;
a third semiconductor structure (3), the third semiconductor structure (3) being connected to the second semiconductor structure (2) through bonding, and the third semiconductor structure (3) comprising a second memory cell;
a first bit-line connection line (204A, 204B), the first bit-line connection line (204A, 204B) being associated with the first memory cell; and
a second bit-line connection line (304A, 304B), the second bit-line connection line (304A, 304B) being associated with the second memory cell;
the first bit-line connection line (204A, 204B) and the second bit-line connection line (304A, 304B) being coupled to each other for comparison by means of the sense amplifier circuit (102); and
a length difference between the first bit-line connection line (204A, 204B) and the second bit-line connection line (304A, 304B) being less than or equal to 2 micrometers.

2. The semiconductor device according to claim 1, wherein
the first memory cell comprises a first memory array (202A) and a second memory array (202B), and the first memory array (202A) and the second memory array (202B) are on a same horizontal plane;
the second memory cell comprises a third memory array (302A) and a fourth memory array (302B), and the third memory array (302A) and the fourth memory array (302B) are on a same horizontal plane; and
the third memory array (302A) is close to the first memory array (202A), and the fourth memory array (302B) is close to the second memory array (202B).

3. The semiconductor device according to claim 2, wherein
the first bit-line connection line (204A, 204B) is associated with the first memory array (202A); and
the second bit-line connection line (304A, 304B) is associated with the third memory array (302A).

4. The semiconductor device according to claim 2, wherein
the first bit-line connection line (204A, 204B) is associated with the first memory array (202A); and
the second bit-line connection line (304A, 304B) is associated with the fourth memory array (302B).

5. The semiconductor device according to any one of claims 1 to 4, wherein
the first memory cell comprises a first bit line (2021), a first transistor (2022), and a first capacitor (2023), and the first capacitor (2023), the first transistor (2022), and the first bit line (2021) are stacked in a vertical direction;
the second memory cell comprises a second bit line (3021), a second transistor (3022), and a second capacitor (3023), and the second bit line (3021), the second transistor (3022), and the second capacitor (3023) are stacked in the vertical direction;
the first bit-line connection line (204A, 204B) is connected to the first bit line (2021); and
the second bit-line connection line (304A, 304B) is connected to the second bit line (3021).

6. The semiconductor device according to claim 5, wherein
the second semiconductor structure (2) comprises a surface close to the first semiconductor structure (1) and a surface close to the third semiconductor structure (3);
the third semiconductor structure (3) comprises a surface close to the second semiconductor structure (2) and a surface away from the second semiconductor structure (2);
the first bit line (2021) is located on the surface that is of the second semiconductor structure (2) and that is close to the third semiconductor structure (3); and
the second bit line (3021) is located on the surface that is of the third semiconductor structure (3) and that is close to the second semiconductor structure (2).

7. The semiconductor device according to claim 6, wherein
the first semiconductor structure (1) further comprises a first interconnection structure (103), the first interconnection structure (103) is located on a surface that is of the first semiconductor structure (1) and that is close to the second semiconductor structure (2), and the first interconnection structure (103) is connected to the sense amplifier circuit (102), and is bonded to the second semiconductor structure (2);
the second semiconductor structure (2) further comprises a second interconnection structure (2044), the second interconnection structure (2044) is located on the surface that is of the second semiconductor structure (2) and that is close to the first semiconductor structure (1), and the second interconnection structure (2044) is bonded to the first semiconductor structure (1);
the second semiconductor structure (2) further comprises a third interconnection structure, the third interconnection structure comprises a first through connection member (2043), a first bit-line connection member (2041), and a first contact member (2042), the first through connection member (2043) is connected to the second interconnection structure (2044), the first bit-line connection member (2041) is separately connected to the first bit line (2021) and the first through connection member (2043), and the first contact member (2042) is located on the surface that is of the second semiconductor structure (2) and that is close to the third semiconductor structure (3), is connected to the first through connection member (2043), and is bonded to the third semiconductor structure (3); and
the third semiconductor structure (3) further comprises a fourth interconnection structure, the fourth interconnection structure comprises a second through connection member (3043), a second bit-line connection member (3041), and a second contact member (3042), the second contact member (3042) is located on the surface that is of the third semiconductor structure (3) and that is close to the second semiconductor structure (2), and is bonded to the first contact member (2042), the second bit-line connection member (3041) is separately connected to the second bit line (3021) and the second contact member (3042), and the second through connection member (3043) is connected to the second contact member (3042).

8. The semiconductor device according to claim 7, wherein
positions at which a plurality of first bit-line connection members (2041) are connected to a plurality of first bit lines (2021) are staggered; and
positions at which a plurality of second bit-line connection members (3041) are connected to a plurality of second bit lines (3021) are staggered.

9. The semiconductor device according to claim 7 or 8, wherein
an effective length of the first bit-line connection member (2041) is equal to an effective length of the second bit-line connection member (3041) coupled to a same sense amplifier circuit (102).

10. The semiconductor device according to claim 7, wherein
the third semiconductor structure (3) further comprises a lead-out structure (305), and the lead-out structure (305) is located on the surface that is of the third semiconductor structure (3) and that is away from the second semiconductor structure (2), and is connected to the second through connection member (3043).

11. A manufacturing method for a semiconductor device, comprising:
providing a first semiconductor structure (1), and forming a sense amplifier circuit (102) in the first semiconductor structure (1);
providing a second semiconductor structure (2), and forming a first memory cell in the second semiconductor structure (2);
providing a third semiconductor structure (3), and forming a second memory cell in the third semiconductor structure (3);
forming the third semiconductor structure (3) on the second semiconductor structure (2) through bonding;
forming the second semiconductor structure (2) on the first semiconductor structure (1) through bonding;
forming a first bit-line connection line (204A, 204B), the first bit-line connection line (204A, 204B) being associated with the first memory cell; and
forming a second bit-line connection line (304A, 304B), the second bit-line connection line (304A, 304B) being associated with the second memory cell;
the first bit-line connection line (204A, 204B) and the second bit-line connection line (304A, 304B) being coupled to each other for comparison by means of the sense amplifier circuit (102); and
a length difference between the first bit-line connection line (204A, 204B) and the second bit-line connection line (304A, 304B) being less than or equal to 2 micrometers.

12. The manufacturing method for a semiconductor device according to claim 11, wherein
the providing a first semiconductor structure (1), and forming a sense amplifier circuit (102) in the first semiconductor structure (1) comprises:
providing a first substrate (101), and forming the sense amplifier circuit (102) and a first interconnection structure (103) on the first substrate (101);
the forming a first memory cell in the second semiconductor structure (2) comprises:
providing a second substrate (201), and forming a first bit line (2021), a first transistor (2022), and a first capacitor (2023) on the second substrate (201), the first bit line (2021), the first transistor (2022), and the first capacitor (2023) being stacked in a vertical direction; and
the forming a second memory cell in the third semiconductor structure (3) comprises:
providing a third substrate (301), and forming a second bit line (3021), a second transistor (3022), and a second capacitor (3023) on the third substrate (301), the second bit line (3021), the second transistor (3022), and the second capacitor (3023) being stacked in the vertical direction.

13. The manufacturing method for a semiconductor device according to claim 12, wherein the forming the third semiconductor structure (3) on the second semiconductor structure (2) through bonding comprises:
forming a first carrier plate (203) and a second carrier plate (303) respectively on the second semiconductor structure (2) and the third semiconductor structure (3);
flipping the second semiconductor structure (2) and the third semiconductor structure (3) to remove the second substrate (201) and the third substrate (301);
forming a first bit-line connection member (2041) and a first contact member (2042) in the second semiconductor structure (2);
forming a second bit-line connection member (3041) and a second contact member (3042) in the third semiconductor structure (3); and
flipping the second semiconductor structure (2), so that the second semiconductor structure (2) is bonded to the third semiconductor structure (3).

14. The manufacturing method for a semiconductor device according to claim 13, wherein the forming the second semiconductor structure (2) on the first semiconductor structure (1) through bonding comprises:
removing the first carrier plate, and forming a first through connection member (2043) and a second interconnection structure (2044) in the second semiconductor structure (2); and
flipping the second semiconductor structure (2), so that the second semiconductor structure (2) is bonded to the first semiconductor structure (1).

15. The manufacturing method for a semiconductor device according to claim 14, after the second semiconductor structure (2) is bonded to the first semiconductor structure (1), further comprising:
removing a third carrier plate, and forming a second through connection member (3043) and a lead-out structure (305) in the third semiconductor structure (3).
